(19) Europäisches Patentamt
European Patent Office
Office européen des brevets

(11) **EP 4 505 195 B1**

(12) **EUROPEAN PATENT SPECIFICATION**

(45) Date of publication and mention
of the grant of the patent:
**20.05.2026 Bulletin 2026/21**

(21) Application number: **23718004.7**

(22) Date of filing: **24.03.2023**

(51) International Patent Classification (IPC):
***G01R 19/25*** *(2006.01)*    ***G01R 31/08*** *(2020.01)*
***H02J 3/00*** *(2026.01)*    ***H02J 13/00*** *(2026.01)*

(52) Cooperative Patent Classification (CPC):
**H02J 13/12; H02J 3/0012; H02J 13/333;**
**H02J 13/34;** G01R 31/08; H02J 2103/30;
H02J 2103/35

(86) International application number:
**PCT/FI2023/050170**

(87) International publication number:
**WO 2023/194654 (12.10.2023 Gazette 2023/41)**

(54) **METHOD AND SYSTEM FOR MANAGEMENT OF ELECTRIC GRID**

VERFAHREN UND SYSTEM ZUR VERWALTUNG EINES STROMNETZES

PROCÉDÉ ET SYSTÈME DE GESTION DE RÉSEAU ÉLECTRIQUE

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(30) Priority: **08.04.2022 FI 20225309**

(43) Date of publication of application:
**12.02.2025 Bulletin 2025/07**

(73) Proprietor: **Safegrid Oy**
**02150 Espoo (FI)**

(72) Inventors:
• **HAKUNTI, Jussi**
**21600 Parainen (FI)**
• **MÄNTYSALO, Tapio**
**21510 Hevonpää (FI)**

(74) Representative: **Moosedog Oy**
**Kurjenmäenkatu 10 B 49**
**20700 Turku (FI)**

(56) References cited:
**WO-A1-2021/108537**    **CN-A- 113 806 899**
**US-B1- 11 183 879**

**Description**

TECHNICAL FIELD

The present invention relates generally to grid management, and more specifically, to a method and a system for management of an electric grid, including estimating grid topology and fault detection.

BACKGROUND

Generally, management of an electric grid comprises accurately detecting technical faults and errors in the electric grid and/or the electrical components operating therein. However, such an operation is a highly complex and cumbersome task. Conventionally, existing systems and/or methods aimed at solving the problem attempted to get the switching state information directly from a customer's distribution management system (DMS); however, such an operation is unable to solve the existing problems in an effective manner due to several reasons including, but not limited to, unavailability of customer data in the DMS, customer may not want to share the data, or other challenges in integration in doing this. As a result, a need for a system or method is developed, which can automatically detect the switching states, thereby enabling path selection between the respective sensors and ultimately enabling accurate fault location in all situations.

Further, in cases wherein the fault transients are detected by multiple sensors (i.e., at least two sensors), wherein using the relative timings based on GPS time stamps, the fault location may be extracted accurately. However, such a method requires, that the path between the sensors is known. Since, in many situations, the path between the sensors is not known, especially in dense and highly branched city networks. Notably, the problem manifests itself due to the unknown states of the switching devices (or disconnectors), remotely controlled or manual. Generally, the state of the switching device is unknown and sometimes even the user (or customer) is unaware of them. Furthermore, in many networks, there may be thousands of switching devices, wherein some may be undocumented and thus, not visible in the Distribution Management Systems (DMS). Moreover, the continuous increase of remotely connected disconnectors (such as, in Nordic markets) and reclosers (in many other markets such as, North and South America, UK, India, etc.), the switching state of network is continuously changing in a dynamic manner with such network elements and thus significantly increases the difficult in managing such electric grids. Thus, a method or a system that automatically regenerates the topology of the network from the current measurements is needed, such that the accurate fault information removes the need for conventional legacy DMS systems.

Furthermore, the prior art (publication number US11183879B1) discloses methods for building an electrical grid topology and detecting faults in an electrical grid are disclosed herein. The method for building an electrical grid topology of an electrical grid comprising a plurality of grid elements, the method comprises sending, from a first signaling module of a plurality of signaling modules of the electrical grid, a mapping signal; receiving, at a second signaling module of the plurality of signaling modules, the mapping signal; and deriving, from the mapping signal, grid characteristics of the electrical grid; wherein the grid characteristics are derived from the mapping signal based on the influence that one or more of the plurality of grid elements has on the mapping signal.

Consequently, in light of the aforementioned problems, a dire need for a system and/or a method for management of electric grids which can automatically detect the switching states, thereby enabling path selection between the respective sensors and ultimately enabling accurate fault detection and/or location in all types of situations (or networks) and thereby, addresses and/or alleviates such problems in an effective and efficient manner.

Therefore, in light of the foregoing discussion, there exists a need to overcome the aforementioned drawbacks associated with known techniques of electrical grid management and fault detection.

SUMMARY

An object of the present invention is to provide a method for management of an electric grid, according to independent claim 1. Another object of the present invention is to provide a system for executing the method for management of the electric grid, according to independent claim 8. Yet another object is to provide a solution that overcomes at least partially the problems encountered in the prior art.

The present invention provides a method for management of an electric grid, the electric grid comprising one or more switching devices and one or more current sensors associated therewith, the method comprising:

- receiving information about measurements of current from each of the one or more current sensors in the electric grid;
- approximating a proxy for a relative current through each of the one or more switching devices based on the received information, wherein the proxy for the relative current indicates the relative power flow or the load current in the one or more switching devices and provides measure of the direction of switching state in the one or more switching devices;

- detecting a change in polarity of the proxy for the relative current for each of the one or more switching devices, as an indication of change in switching state of the corresponding one of the one or more switching devices;
- calculating correlation between the one or more current sensors based on the measurements of current therethrough and the detected change in the switching state of the associated one or more switching devices;
- determining relative installation directions of each of the one or more current sensors based on the determined correlation therebetween; and
- generating a network topology of the electric grid based on the determined relative installation directions of each of the one or more current sensors, wherein a correlation matrix is generated based on the determined relative installation directions of each of the one or more current sensors and the calculated correlation between each of the one or more current sensors to generate the network topology of the electric grid

wherein the method comprising determining a fault location, in case of a fault in the electric grid, corresponding to one of the one or more switching devices in the electric grid utilizing information about the generated network topology of the electric grid, wherein the fault location is extracted accurately when fault transients are detected by at least two sensors using relative timings based on GPS time stamps.

In another aspect, the present invention provides a system for management of an electric grid, the electric grid comprising one or more switching devices and one or more current sensors associated therewith, the system comprising:

- a sensing unit coupled with each of the one or more current sensors to collect and transmit information about measurements of current by the corresponding current sensors in the electric grid; and
- a control unit in signal communication with each of the sensing units, the control unit configured to:

    - receive information about measurements of current from each of the one or more current sensors in the electric grid;
    - approximate a proxy for a relative current through each of the one or more switching devices based on the received information, wherein a correlation matrix is generated based on the determined relative installation directions of each of the one or more current sensors and the calculated correlation between each of the one or more current sensors to generate the network topology of the electric grid;
    - detect a change in polarity of the proxy for the relative current for each of the one or more switching devices, as an indication of change in switching state of the corresponding one of the one or more switching devices;
    - calculate correlation between the one or more current sensors based on the measurements of current therethrough and the detected change in the switching state of the associated one or more switching devices;
    - determine relative installation directions of each of the one or more current sensors based on the determined correlation therebetween; and
    - generate a network topology of the electric grid based on the determined relative installation directions of each of the one or more current sensors, wherein a correlation matrix is generated based on the determined relative installation directions of each of the one or more current sensors and the calculated correlation between each of the one or more current sensors to generate the network topology of the electric grid

wherein the control unit is further configured to determine a fault location, in case of a fault in the electric grid, corresponding to one of the one or more switching devices in the electric grid utilizing the information about the generated network topology of the electric grid, wherein the fault location is extracted accurately when fault transients are detected by at least two sensors using relative timings based on GPS time stamps.

The disclosed embodiments substantially eliminate or at least partially address the aforementioned problems in the prior art, and enable efficient and effective management of the electric grid via the method or the system.

Additional aspects, advantages, features and objects of the present disclosure will be made apparent from the drawings and the detailed description of the illustrative embodiments construed in conjunction with the appended claims that follow. The scope of the invention is defined only by the appended claims.

It will be appreciated that features of the present disclosure are susceptible to being combined in various combinations without departing from the scope of the present invention as defined by the appended claims.

BRIEF DESCRIPTION OF DRAWINGS

Embodiments of the present invention will now be described, by way of example only, with reference to the following diagrams wherein:

    FIG. 1 is an illustration of a flowchart of a method for management of an electric grid, in accordance with an embodiment;

FIG. 2 is a block diagram of a system for management of an electric grid, in accordance with an embodiment;

FIGs. 3A-3C are schematic illustrations of different exemplary electric grids to be managed by the present system and the present method, in accordance with an embodiment;

FIGs. 4A and 4B are graphical illustrations of time series associated with the current measurements flowing through the electric grid, in accordance with an embodiment;

FIG. 5 is a graphical illustration depicting relationship between the number of samples and the magnitude of correlation between the one or more current sensors, in accordance with an embodiment; and

FIG. 6 illustrates an exemplary network topology of an electric grid generated by the present system and the present method, in accordance with an embodiment.

DETAILED DESCRIPTION OF EMBODIMENTS

The following detailed description illustrates embodiments of the present invention and ways in which they can be implemented. Although some modes of carrying out the present invention have been disclosed, those skilled in the art would recognize that other embodiments for carrying out or practicing the present invention are also possible, as long as they do not depart from the scope of the invention as defined by the appended claims.

In an aspect, an embodiment provides a method for management of an electric grid, the electric grid comprising one or more switching devices and one or more current sensors associated therewith, the method comprising:

- receiving information about measurements of current from each of the one or more current sensors in the electric grid;
- approximating a proxy for a relative current through each of the one or more switching devices based on the received information, wherein the proxy for the relative current indicates the relative power flow or the load current in the one or more switching devices and provides measure of the direction of switching state in the one or more switching devices;
- detecting a change in polarity of the proxy for the relative current for each of the one or more switching devices, as an indication of change in switching state of the corresponding one of the one or more switching devices;
- calculating correlation between the one or more current sensors based on the measurements of current therethrough and the detected change in the switching state of the associated one or more switching devices;
- determining relative installation directions of each of the one or more current sensors based on the determined correlation therebetween; and
- generating a network topology of the electric grid based on the determined relative installation directions of each of the one or more current sensors, wherein a correlation matrix is generated based on the determined relative installation directions of each of the one or more current sensors and the calculated correlation between each of the one or more current sensors to generate the network topology of the electric grid.

In another aspect, the present invention provides a system for management of an electric grid, the electric grid comprising one or more switching devices and one or more current sensors associated therewith, the system comprising:

- a sensing unit coupled with each of the one or more current sensors to collect and transmit information about measurements of current by the corresponding current sensors in the electric grid; and
- a control unit in signal communication with each of the sensing units, the control unit configured to:

  - receive information about measurements of current from each of the one or more current sensors in the electric grid;
  - approximate a proxy for a relative current through each of the one or more switching devices based on the received information, wherein the proxy for the relative current indicates the relative power flow or the load current in the one or more switching devices and provides measure of the direction of switching state in the one or more switching devices;
  - detect a change in polarity of the proxy for the relative current for each of the one or more switching devices, as an indication of change in switching state of the corresponding one of the one or more switching devices;
  - calculate correlation between the one or more current sensors based on the measurements of current therethrough and the detected change in the switching state of the associated one or more switching devices;
  - determine relative installation directions of each of the one or more current sensors based on the determined correlation therebetween; and
  - generate a network topology of the electric grid based on the determined relative installation directions of each of the one or more current sensors, wherein a correlation matrix is generated based on the determined relative installation directions of each of the one or more current sensors and the calculated correlation between each of the one or more current sensors to generate the network topology of the electric grid.

The present invention provides a method for management of an electric grid. The electric grid comprises one or more switching devices and one or more current sensors associated therewith. The term *"electric grid"* as used herein refers to a type of interconnected electrical network configured to deliver electricity to (or from) the connected elements therein. Herein, the electric grid is configured to operate between a set of the electrical components such as, switching devices, electrical stations, and other electrical and/or electronic elements operating within the electric grid. The term *"switching devices"* as used herein refers to a type of switch or circuit breaker operating within the electric grid such as, but not limited to, disconnectors, reclosers, sectionalizers, isolators, and the like. Herein, the use of term "current" may generally refer to "load current," with the two terms being interchangeably used hereinafter. Further, the term *"current sensor"* as used herein refers to an electrical device configured to sense and/or measure the value of a current flowing therethrough. For example, the current sensor may be selected from at least one of a current transformer, a fall-effect sensor, a magnetic sensor, a Rogowski coil, a fiber optic sensor, and the like. It will be appreciated that the method is enabled to manage various types of current sensors and switching devices and not limited to the aforementioned types without limiting the scope of the present invention, only defined by the appended claims.

Typically, the method is configured to manage and/or monitor the technical (such as, faults and errors) and non-technical aspects (such as, fraud and theft) associated with the electric grid and the operating components therein. Moreover, the method for management of the electric grid may be further configured to monitor energy losses in the electric grid, monitor energy and service quality, manage load shedding, and the like to enable the electric grid to operate effectively and efficiently. However, accurately detecting such technical faults and errors is a highly complex and cumbersome task. Conventionally, existing systems and/or methods aimed at solving the problem attempted to get the switching state information directly from a user's distribution management system (DMS); however, such an operation is unable to solve the existing problems in an effective manner due to several reasons including, but not limited to, unavailability of customer data in the DMS, customer may not want to share the data, or several tremendous challenges in integration in doing this. As a result, a need for a system or method is developed, which can automatically detect the switching states, thereby enabling path selection between the respective sensors and ultimately enabling accurate fault location in all situations.

Generally, the method is configured such that fault transients are detected by multiple sensors (i.e., at least two sensors), wherein using the relative timings based on GPS time stamps, the fault location may be extracted accurately. However, such a method requires, that the path between the sensors is known. Since, in many situations, the path between the sensors is not known, especially in dense and highly branched city networks. Notably, the problem manifests itself due to the unknown states of the switching devices (or disconnectors), remotely controlled or manual. Generally, the state of the switching device is unknown and sometimes even the user (or customer) is unaware of them. Further, in many networks, there may be thousands of switching devices, wherein some may be undocumented and thus, not visible in the Distribution Management Systems (DMS). Moreover, the continuous increase of remotely connected disconnectors (such as, in Nordic markets) and reclosers (in many other markets such as, North and South America, UK, India, etc.), with such network elements the switching state of network is continuously changing in a dynamic manner.

The present method comprises receiving information about measurements of current from each of the one or more current sensors in the electric grid. Typically, the method is configured to receive information about the measurements of the current as measured by each of the one or more current sensors in the electric grid to determine the value of the raw phase currents flowing thereat. Herein, the information about the measurements of the current may be received from an electric station or sub-station in the electric grid, or may be received automatically via the one or more current sensors, or received from any other monitoring and/or measurement systems. Beneficially, the information of the current measurements enables the method to utilize the information related to the phase currents to be further analyzed and processed to determine information associated with the load current, in order to enable effective management of the electric grid as explained further in the present disclosure.

The method further comprises approximating a proxy for a relative current through each of the one or more switching devices based on the received information. The term *"proxy for relative current"* as used herein refers to a proxy for the load current that indicates the relative power flow in the one or more switching devices and provides an alternative to measure the direction of switching states, wherein the relative current is a load current whose measurement of value and polarity acts as the proxy of the direction of switching state of the one or more switching devices. Typically, the information about the measurements of the current derived from the one or more current sensors is used to approximate the relative power flow or the load current through each of the switching devices in order to determine the location of any switching device of the one or more switching devices. Beneficially, such an approximation enables the method to determine the switching state of each of the one or more switching devices, that is further utilized by the method to determine the location of the one or more switching devices for effective management of the electric grid. Herein, the relative current is calculated from individual phase current measurements, or measurements from individual conductors in the associated electrical network. Typically, the conductors from which current is measured are combined in a special way such that the relative current may be estimated from these individual phase current measurements. Moreover, the calculated relative currents are location specific and thus, used for the automatic determination of the network topology.

In one or more embodiments, approximating the proxy for the relative current through each of the one or more switching devices comprises transforming measurements of current to sequence space, to determine a positive sequence current component and a negative sequence current component for each of phase orders for the measurements of phase current and combining the positive sequence current component and the negative sequence current component, for approximating the proxy for the relative current. Typically, the generation or approximation of the proxy for the relative current flowing through each of the one or more switching devices may be done by transforming the received measurements of phase currents associated with the one or more current sensors to the sequence space. Herein, the transformation is performed to determine the positive and the negative sequence current components for each of the phase orders, wherein the positive and the negative sequence current component are combined to measure the proxy of relative currents i.e., the proxy for the relative current and their directions therein.

In an exemplary implementational scenario of an electric grid, wherein symmetrical components are employed as proxy for power flows. The electric grid comprises a first sensor (such as, a Safegrid™ sensor) having three Rogowski sensors (A, B, C) for measuring currents of a magnitude of 50 hertz (Hz).

Herein, currents flowing through each of the three Rogowski sensors (assuming currents to be symmetrical), are represented as:

$$I_a = I_p \times \mathrm{Sin}\ [\omega t]$$

$$I_b = I_p \times \mathrm{Sin}\ [\omega t + (2\ \pi)/3]$$

$$I_c = I_p \times \mathrm{Sin}\ [\omega t + (4\ \pi)/3]$$

wherein, $I_a$, $I_b$, $I_c$ are symmetrical currents through each of the three Rogowski sensors; $I_p$ is the measured value of phase current, $\omega$ is the angular frequency, and t is the point in time.

Often, the sequence currents are represented as phasors (in a fully symmetric case or in an asymmetric case), wherein 'a' is the phase shift operator, phase angle is 120 degrees: $It = I_p\ [1\ a\ a^2]$. However, since there are multiple ways to install a Rogowski sensor which are not known and thus, the associated phase orderings are also not available. Thus, there can be different ways to observe the same current It, as shown:

$$I_{t1} = I_p\ [1\ a\ a^2]\ \text{and}\ I_{t2} = I_p\ [1\ a^2\ a]$$

Herein, the method comprises transforming measurements of current i.e., the current vectors to sequence space (i.e., positive sequence, negative sequence, zero sequence) using the following matrix:

$$A = \frac{1}{3}\begin{bmatrix} 1 & 1 & 1 \\ 1 & a & a^2 \\ 1 & a^2 & a \end{bmatrix}$$

Now, taking the transform of the above two current measurements with different phase orderings, we get these sequence currents:

$$A.I_{t1} = \begin{bmatrix} 0 \\ 0 \\ I_p \end{bmatrix}\quad,$$

and

$$A.I_{t2} = \begin{bmatrix} 0 \\ I_p \\ 0 \end{bmatrix}$$

Herein, the pseudocode for approximating or determining the value of $I_a$ (proxy for current carrying the load current) is as follows:

$$\text{IF } |I_{pos}| >> 0 \text{ and } |I_{neg}| = \text{small, THEN } I_a = I_{pos};$$

and

$$\text{IF } |I_{neg}| >> 0 \text{ and } |I_{pos}| = \text{small, THEN } I_a = I_{neg}.$$

The resulting $I_a$ can have any sign, i.e., positive or negative. However, while the relative current approximation may be done as explained above, the method is unable to provide the direction of current or power flow. This is due to the fact, that there are multiple ways to install Rogowski sensors correctly (and whole lot of more ways to do it wrong, but which are easy to detect). Therefore, symmetrical components do not disclose the direction of power flows, just an approximation of the power level being transmitted. To overcome the aforementioned problems, existing systems and methods have tried to request users to install the Rogowski sensors correctly or in a specific manner (chosen from 12 different alternatives). However, this is not possible, since installation persons more often than not are unaware of the phase orderings, or about direction of outgoing feeders in secondary substation, or, it might be known, but not available to the installation person. Thus, there still exists a need for a method or a system which can accurately determine the magnitude as well as the direction of the current flowing in the electric grid.

In an embodiment, combining the positive sequence current component and the negative sequence current component comprises using larger of the positive sequence current component and the negative sequence current component. Typically, since the load currents have a higher value than other transient currents, thus the sequence current component with the larger value is selected to be combined for approximating the relative power flow (or the relative current) in the electric grid to ensure accurate and precise management of the electric grid. Thus, simply stated, depending on the phase ordering, the relative current can manifest itself either as positive sequence or negative sequence current. Therefore, the expression ($I_a$) as described above is a good proxy for the value of current carrying power to load, where it will be appreciated that in all practical cases negative sequence current is much smaller, than positive sequence current which carries the load.

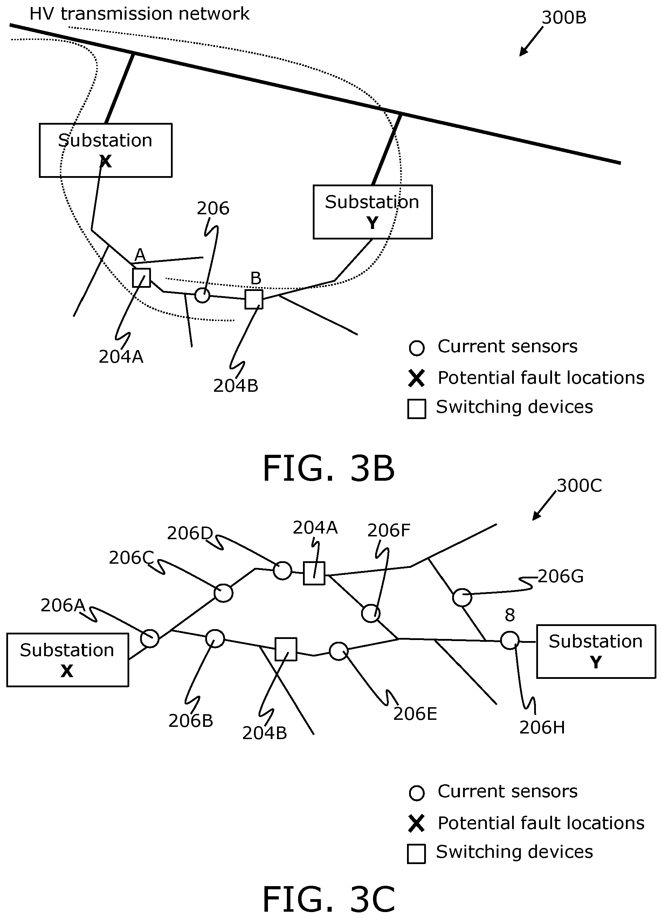

The method further comprises detecting a change in polarity of the proxy for the relative current for each of the one or more switching devices, as an indication of change in switching state of the corresponding one of the one or more switching devices. The approximation of the proxy of the relative current for the one or more current sensors comprises the generation of the sequence current components that provides immediate or real-time information about the occurrence of change in switching state of the one or more switching devices. Typically, in any distribution service area covered by distribution grid operator, the supply comes from the high voltage grid and the phases are of the same order. Therefore, when the switching state changes (for example, a first switching device A opens and a second switching device B closes as shown in FIG. 3B), the direction of the relative current changes. This, in turn, is manifested by a sign change in $I_a$. Therefore, any sign change of $I_a$ is a real time signal, that indicates occurrence of a change of switching state.

The method further comprises calculating correlation between the one or more current sensors based on the measurements of current therethrough and the detected change in the switching state of the associated one or more switching devices. The term *"correlation"* as used herein refers to a type of statistical correlation derived between the one or more current sensors and the one or more switching devices via the method. For example, the correlation may be an incidence matrix, a cross correlation matrix, or a mathematical tool such as, mean or average, standard deviation, covariance, regression, and the like. Typically, upon detecting a change in the switching state of any of the one or more switching devices i.e., a change in the polarity of the relative current (or load current, $I_a$), a correlation between the associated one or more current sensors is calculated (or determined) based on the received information of the measurements of the current (i.e., the sequence space) flowing therethrough. Alternatively stated, if there is a correlation between at least two sensors of the one or more current sensors, the two current sensors are on the same path calculated from the substation. Correspondingly, if there is no correlation, then the sensors are on different branches of the network. Such a calculation of the correlation enables the method to determine the topology of the network. Beneficially, the calculation of the correlation enables the method to determine the magnitude and polarity of the relative currents and thereby, which further enables the method to determine the location of the one or more switching devices in the electric grid for effective management thereof.

In one or more embodiments, the correlation between the one or more current sensors is calculated based on a covariance of the measurements of current therethrough. Typically, the covariance of the measurements of the current enables the method to calculate the correlation between the one or more current sensors in the electric grid. The *"covariance"* indicates the relationship between any two random variables (such as, the measured phase currents or the calculated relative currents), and is utilized by the method to determine the correlation between the one or more current sensors and the one or more switching devices in the electric grid. In example, a zero covariance implies that the current sensors are present in totally different sections of the electric grid. Alternatively stated, the current sensors are not connected at all. In another example, a large covariance implies that the current sensors are present in the same segment (or section). It will be appreciated that the terms correlation, cross correlation and covariance may be interchangeably employed throughput the present disclosure. Such implications via the covariance enables the method to derive useful information related to the one or more current sensors (such as, power flow, location, polarity, and the like) and directly indicates about the topology of the electric grid.

In one or more embodiments, the method further comprises implementing a threshold for the covariance of the measurements to be used for calculating the correlation between the one or more current sensors. The term *"threshold"* as used herein refers to a minimum value of co-variance required to be considered for determination of the correlation between the current sensors. Typically, for calculating the correlation between the one or more current sensors, the threshold is implemented to only consider the co-variance having a value higher than the threshold to only consider the load currents and thus, minimizes the possibility of errors in the method and thereby, makes the method more effective and/or accurate.

In one or more embodiments, the method further comprises using a signal-to-noise ratio value in an inversely proportional relationship for calculating the correlation between the one or more current sensors. It is known by a person skilled in the art that the current measurements by the one or more current sensors generally contains noise and thus, to remove the inherent noise in the measurements, the method further comprises using the signal to noise ratio (SNR) as a ratio between the covariances of the signals. Thus, considering current measured currents to be $I_{M1}$ and $I_{M2}$. The measured current may be represented as $I_{M1} = I_{A1} + e_1$ and $I_{M2} = I_{A2} + e_2$, wherein $e_1$ and $e_2$ are corresponding noises in the measurements, and wherein $I_{A1}$ and $I_{A2}$ are the corresponding actual current measurements. Herein, the SNR is determined as $= \frac{\sigma_{IA1}^2}{\sigma_{e1}^2} = \frac{\sigma_{IA2}^2}{\sigma_{e2}^2}$.

Then, the statistical correlation between two random variables is represented as:

$$p_{XY} = \frac{E[(I_{A1} + e_1)(I_{A2} + e_2)]}{\sqrt{E[(I_{A1} + e_1)^2]E[(I_{A2} + e_2)^2]}} = \frac{E[I_{A1}I_{A2}]}{\sqrt{(\sigma_{Ia1}^2 + \sigma_{e1}^2)(\sigma_{Ia2}^2 + \sigma_{e2}^2)}}$$

$$= \frac{E[I_{A1}I_{A2}]}{\sqrt{\sigma_{Ia1}^2 \left(1 + \frac{1}{SNR}\right) \sigma_{Ia2}^2 \left(1 + \frac{1}{SNR}\right)}}$$

Thereby, the correlation between the current sensors becomes

$$\frac{E[I_{A1}I_{A2}]}{\sqrt{\sigma_{Ia1}^2 \sigma_{Ia2}^2}} \frac{1}{1 + \frac{1}{SNR}}.$$

As a result, it may be observed that the statistical correlation with SNR is defined in an inversely proportional manner to the SNR (as observed in, $1 + \frac{1}{SNR}$). In an example, if the SNR is 10, then the statistical correlation is reduced by a factor of 0.9. In another example, if the SNR is 2, then the statical correlation is reduced by a factor of 0.7. Beneficially, the SNR indicates the usefulness of the correlation between any of the one or more current sensors.

In one or more embodiments, the method further comprises using an average of at least a predefined number of covariances of the measurements for calculating the correlation between the one or more current sensors. Typically, to calculate the correlation between the one or more current sensors the method further comprises averaging at least a predefined number of co-variances of the measurements. The *"predefined number"* relates to a minimum number of co-variances to be utilized for determination of the correlation between the one or more current sensors. Beneficially, such a computation enables the method to minimize the noise in the measurements of the current values and thus enables the method to accurately approximate the current values thereof for effectively managing the electric grid.

In an exemplary implementational scenario, the electric grid (as shown in FIG. 3B) comprises two sensors (i.e., a first and a second sensor) in one feeder network, wherein the first sensor is closer to substation and the second sensor is a few kilometers away such that there may be a few secondary substations therebetween. Herein, the power 'P₁' measured by the first sensor is approximately equal to the power measured by the second sensor $P_2$ in addition to the value of the load carried out by the secondary substations between the two sensors. Generally, in power flow and load analysis, $P_1$, $P_2$ and $P_x$ may be random variables with some defined variances, autocorrelation and similar statistical properties. Therefore, $P_1$ and $P_2$ are also correlated as follows: $P_1 = P_2 + P_x$. Moreover, in cases wherein the sensors are located such that, the sensors are fed by two different substations or are located in in different branches of the electric grid, there should be a little correlation between the two sensors. Since, in practical settings it is non-zero due to the spuriousness experienced in correlations, especially with smaller sample sizes and due to some common sources (e.g., certain times instants triggering similar actions in different consumers).

In another exemplary scenario of the electric grid (as shown in FIG. 3C), the electric grid comprises one or more current sensors (eight sensors, as shown) arranged between two different substations and one or more switching devices (two reclosers, as shown). It may be observed that a first current sensor (A) of the one or more current sensors is mutually correlated to a second current sensor (B) and a third current sensor (C); However, the second current sensor and the third current sensor are not correlated to each other. Thus, the determination of the power or current through any of the three nodes (or current sensors) may be determined by determining the mutual correlation therebetween.

Herein, in the present example, considering only the order of magnitudes with variables having zero mean for simplicity, the correlation determined by the method between X and Y is represented as: $p_{XY} = \dfrac{\sigma_{XY}}{\sqrt{\sigma_x^2 \sigma_y^2}}$, wherein the term 'X' represents to the power flow at a point located in the beginning of the feeder grid, 'Y' represents the power flow at a point located further from 'X', and '$p_{XY}$' represents the level of cross relation between the two power flows (i.e., between X and Y).

Thus, considering the electric grid of the present example, X = Y + Z and thus, the corresponding statistical correlation becomes:

$$p_{XY} = \frac{E[(y+z)y]}{\sqrt{E[(y+z)^2]}\sigma_y} \; ,$$

$$p_{XY} = \frac{\sigma_y}{\sqrt{\sigma_y^2 + \sigma_z^2}}$$

Notably, since it may be reasonably expected by a person skilled in the art that the standard deviation of a sum of random variables scales by 'N' reasonable assumptions would be, that $\sigma_{z2}$ is $K^2 \sigma_{y2}$, wherein 'K' is the ratio between powers 'Z' and 'Y'. In other words, if the downstream sensor has a 10A measurement and upstream has 50A measurement, then K=4. Thus, correspondingly the statistical correlation becomes:

$$p_{XY} = (1/\sqrt{(1+K^2)}).$$

Assuming, $|P_{XY}|$ is greater than 0.2 (for meaningful conclusions), then the corresponding value of K is lesser than 5. Thus, in an example, with 10A in downstream sensor, using the aforementioned assumption, the method may detect the correlation in the upstream sensor to up to 60A accurately and efficiently.

The method further comprises determining relative installation directions of each of the one or more current sensors based on the determined correlation therebetween. Typically, the correlation between the one or more current sensors determined based on the calculated covariances thereof (as previously explained in the present disclosure) enables the method to further determine the relative installation direction of each of the one or more current sensors. In one or more embodiments, the relative installation direction of two of the one or more current sensors is determined to be same if the calculated correlation therebetween is close to 1 and to be opposite if the calculated correlation therebetween is close to -1.

In an example considering the correlated power flows in the two sensors of the electric grid, and assuming that the correlation is high (i.e., the sensors are close to each other). In such cases, if the current sensors (Rogowski) are installed in the same direction, then correlation is close to 1 and if the current sensors are not installed in the same direction, then the correlation is close to -1. Thus, beneficially, the correlation data indicates the relative direction installation directions of each of the one or more current sensors since if the installation direction of any of the current sensor is known, then the installation directions of all the correlated current sensors may be determined easily.

The method further comprises generating a network topology of the electric grid based on the determined relative installation directions of each of the one or more current sensors. The term *"network topology"* refers to a physical and/or a logical relationship between any or all nodes (such as, the one or more current sensors, the one or more switching devices) in a network (such as, the electric grid), the schematic arrangement of the links and nodes, or some hybrid combination thereof. Typically, to determine the network topology of the electric grid, the method further comprises generating a correlation matrix based on the determine relative installation directions and the calculated correlation between each of the one or more current sensors. Notably, the correlation matrix is also referred to as the incidence matrix, which has 1 to -1 mapping during graphing into an incidence graph (or a directed graph) that in turn generates the network topology of the electric grid. Moreover, the method allows determining the topology of the network (connection of the sensors, their distances etc.) automatically without users having to enter any data. Beneficially, once the network topology is generated and each of the one or more current sensors are located, any future faults and/or inefficiencies in the electric grid and the electric components therein are managed (or addressed) effectively and efficiently using the method.

In one or more embodiments, the method further comprises determining a fault location, in case of a fault in the electric grid, corresponding to one of the one or more switching devices in the electric grid utilizing the information about the generated network topology of the electric grid. Typically, the generated network topology is utilized by the method to determine the fault location in case of a fault in the electric grid by quickly determining the associated switching device in which the fault has occurred and thereby determining the fault location in a quick and efficient manner.

Beneficially, such an automatic regeneration of topology provides many benefits such as, but not limited to, accurate fault location (the path between any two sensors is known), installation direction of all Rogowski sensors. Further, the method prevents the conventional guessing operation on polarities, and alternatively turns the polarities of all the Rogowski sensors in the same direction. Moreover, the fault direction algorithm process becomes much simpler and more reliable. This is, because major challenge in current solutions, that the installation direction of Rogowski coils is not known and thus, reducing the uncertainty makes finding fault direction relatively easy for pulse and Fourier phase-based methods and even in cases, where only one current sensor can detect the fault event.

Furthermore, for many users outside Nordic countries that generally do not have well developed DMS systems generally the states of disconnectors is unknown, or even the location of them, thus this automatic regeneration of network topology would be of great use for automatic dynamic network topology regeneration and provision of valuable dynamical information to the respective databases (of the external organizations), which in turn would provide operational benefits to the distribution grid operators.

The present invention also provides a system for management of an electric grid. The various embodiments and variants disclosed above apply *mutatis mutandis* to the present system without any limitations.

Thus, the present invention also provides a system for management of an electric grid, the electric grid comprising one or more switching devices and one or more current sensors associated therewith. The system comprising a sensing unit coupled with each of the one or more current sensors to collect and transmit information about measurements of current by the corresponding current sensors in the electric grid and a control unit in signal communication with each of the sensing units.

The term *"sensing unit"* refers to a structure and/or module that includes programmable and/or non-programmable components configured to store, process and/or share information and/or signals relating to measurements of the current via the one or more current sensors. Typically, the sensing unit is operable to perform one or more operations for sensing or collecting information relating to the measurements of the current and thereby transmitting them to any other computation device upon requirement. Optionally, the sensing unit includes any arrangement of physical or virtual computational entities capable of enhancing information to perform various computational tasks. Further, it will be appreciated that the sensing unit may be implemented as a hardware processor and/or plurality of hardware processors operating in a parallel or in a distributed architecture to improve the computational efficiency of the system. Optionally, the sensing unit is supplemented with additional computation system, such as neural networks, and hierarchical clusters of pseudo-analog variable state machines implementing artificial intelligence algorithms. In the present examples, the sensing unit may include components such as memory, a processor, a network adapter and the like, to store, process and/or share information with other computing components, such as a user device, a remote server unit, a database arrangement.

Optionally, the sensing unit is implemented as a computer program that provides various services (such as database service) to other devices, modules or apparatus. Moreover, the sensing unit may refer to a computational element that is operable to respond to and processes instructions to perform the management of the electric grid. Optionally, the sensing unit includes, but is not limited to, a microprocessor, a micro-controller, a complex instruction set computing (CISC) microprocessor, a reduced instruction set (RISC) microprocessor, a very long instruction word (VLIW) microprocessor, Field Programmable Gate Array (FPGA) or any other type of processing circuit, for example as aforementioned.

Additionally, the sensing unit is arranged in various architectures for responding to and processing the instructions for management of the electric grid via the method or system. Herein, the system elements may communicate with each other using a communication interface. The communication interface includes a medium (e.g., a communication channel) through which the system components communicate with each other. Examples of the communication interface include, but are not limited to, a communication channel in a computer cluster, a Local Area Communication channel (LAN), a cellular communication channel, a wireless sensor communication channel (WSN), a cloud communication channel, a Metropolitan Area Communication channel (MAN), and/or the Internet. Optionally, the communication interface comprises one or more of a wired connection, a wireless network, cellular networks such as 2G, 3G, 4G, 5G mobile networks, and a Zigbee connection.

The term *"control unit"* as used herein refers to a structure and/or module that includes programmable and/or non-programmable components configured to store, process and/or share information and/or signals for management of the electric grid. The control unit may be having elements, such as a display, control buttons or joysticks, processor, memory and the like. Typically, the control unit is operable to perform one or more operations for managing the electric grid. Optionally, the control unit includes any arrangement of physical or virtual computational entities capable of enhancing information to perform various computational tasks. Optionally, the control unit is supplemented with additional computation systems, such as neural networks, and hierarchical clusters of pseudo-analog variable state machines implementing artificial intelligence algorithms. In the present examples, the control unit may include components such as memory, a controller, a network adapter and the like, to store, process and/or share information with other components, such as a current sensor, a voltage sensor, a remote server unit, a database. Optionally, the control unit is implemented as a computer program that provides various services (such as database service) to other devices, modules or apparatus. Moreover, the control unit refers to a computational element that is operable to respond to and processes instructions for management of the electric grid. Optionally, the control unit includes, but is not limited to, a microcontroller, a microcontroller, a complex instruction set computing (CISC) microcontroller, a reduced instruction set (RISC) microcontroller, a very long instruction word (VLIW) microcontroller, Field Programmable Gate Array (FPGA) or any other type of processing circuit, for example as aforementioned. Beneficially, the control unit enables the system and/or the method to effectively manage the electric grid and to ensure a safe and robust performance thereat.

Additionally, the control unit is arranged in various architectures for responding to and processing the instructions for management of the electric grid via the method or system. Herein, the system elements may communicate with each other using a communication interface. The communication interface includes a medium (e.g., a communication channel) through which the system components communicate with each other. Examples of the communication interface include, but are not limited to, a communication channel in a computer cluster, a Local Area Communication channel (LAN), a cellular communication channel, a wireless sensor communication channel (WSN), a cloud communication channel, a Metropolitan Area Communication channel (MAN), and/or the Internet. Optionally, the communication interface comprises one or more of a wired connection, a wireless network, cellular networks such as 2G, 3G, 4G, 5G mobile networks, and a Zigbee connection.

The control unit configured to receive information about measurements of current from each of the one or more current sensors in the electric grid, approximate a proxy for a relative current through each of the one or more switching devices based on the received information, detect a change in polarity of the proxy for the relative current for each of the one or more switching devices, as an indication of change in switching state of the corresponding one of the one or more switching devices, calculate correlation between the one or more current sensors based on the measurements of current therethrough and the detected change in the switching state of the associated one or more switching devices, determine relative installation directions of each of the one or more current sensors based on the determined correlation therebetween and generate a network topology of the electric grid based on the determined relative installation directions of each of the one or more current sensors.

In one or more embodiments, for approximating the proxy for the relative current through each of the one or more switching devices, the control unit is configured to: transform measurements of current to sequence space, to determine a positive sequence current component and a negative sequence current component for each of phase orders for the measurements of current; and combine the positive sequence current component and the negative sequence current component, for approximating the proxy for the relative current.

In one or more embodiments, the control unit is configured to calculate the correlation between the one or more current sensors based on a covariance of the measurements of current therethrough.

In one or more embodiments, the control unit is configured to determine the relative installation direction of two of the one or more current sensors to be same if the calculated correlation therebetween is close to 1 and to be opposite if the calculated correlation therebetween is close to -1.

In one or more embodiments, the control unit is further configured to determine a fault location, in case of a fault in the electric, corresponding to one of the one or more switching devices in the electric grid utilizing the information about the generated network topology of the electric grid. In one or more embodiments, the one or more switching devices are one of: disconnectors and reclosers.

In one or more embodiments, the one or more current sensors are Rogowski coils.

DETAILED DESCRIPTION OF DRAWINGS

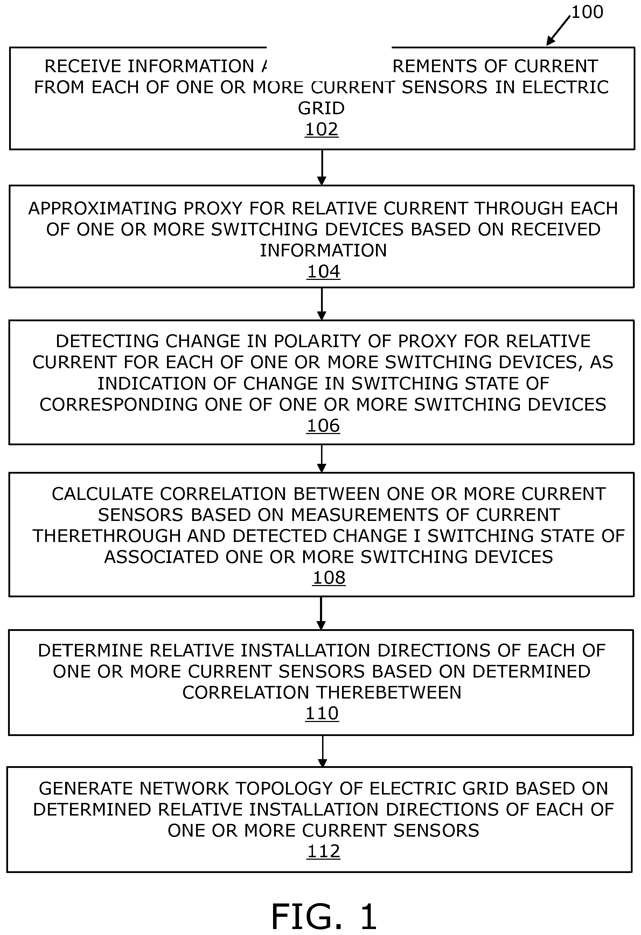

Referring to FIG. 1, illustrated is a flowchart illustrating steps involved in a method **100** for management of an electric grid, in accordance with an embodiment of the present invention. As shown, the method **100** comprises the steps **102, 104, 106, 108, 110** and **112.**

At step **102,** the method **100** comprises receiving information about measurements of current from each of the one or more current sensors in the electric grid. Typically, the measurements of the raw phase currents are received to be further processed by the method to enable management of the electric grid.

At step **104,** the method **100** further comprises approximating a proxy for a relative current through each of the one or more switching devices based on the received information. The proxy for the relative current i.e., the polarity of the associated load current acts the signal for the change in direction of switching state of the one or more switching devices.

At step **106,** the method **100** further comprises detecting a change in polarity of the proxy for the relative current for each of the one or more switching devices, as an indication of change in switching state of the corresponding one of the one or more switching devices. Typically, upon detecting a change in the polarity of the proxy of the relative current for each of the one or more switching devices, a corresponding change in the switching state of the corresponding one or more switching devices is inferred by the method **100.**

At step **108,** the method **100** further comprises calculating correlation between the one or more current sensors based on the measurements of current therethrough and the detected change in the switching state of the associated one or more switching devices. Typically, the correlation between the one or more current sensors enables the method to further determine the relative installation directions of each of the one or more current sensors that has proven to be a significant problem yet to be effectively solved by existing methods or systems.

At step **110,** the method **100** further comprises determining relative installation directions of each of the one or more current sensors based on the determined correlation therebetween. The relative installation directions of each of the one or more current sensors along with the received information (such as, the information about the current, or location or GPS information associated with the one or more current sensors and/or the one or more switching devices) enables the method **100** to thereby determine the network topology for effective management of the electric grid.

And, at step **112,** the method **100** further comprises generating a network topology of the electric grid based on the determined relative installation directions of each of the one or more current sensors. The generation of the network topology enables the method **100** to efficiently and accurately determine the faults occurring in the electric grid and thus, enables the method to effectively manage the electric grid.

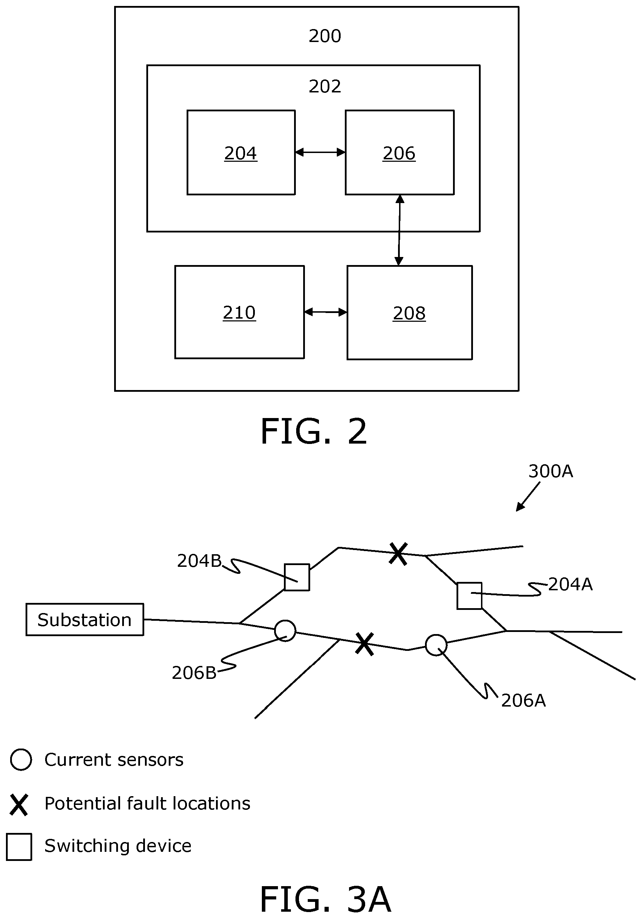

Referring to FIG. 2, illustrated is a block diagram of a system **200** for management of an electric grid **202,** the electric grid **202** comprising one or more switching devices **204** and one or more current sensors **206** associated therewith, in accordance with an embodiment. As shown, the system **200** comprises a sensing unit **208** coupled with each of one or more current sensors **206** to collect and transmit information about measurements of current by the corresponding current sensors **206** in the electric grid **202** and a control unit **210** in signal communication with the sensing unit **208.** Typically, the control unit **210** configured to receive information about measurements of current from each of the one or more current sensors **206** in the electric grid **202,** approximate a proxy for a relative current through each of the one or more switching devices **204** based on the received information. Further, the control unit **210** is configured to detect a change in polarity of the proxy for the relative current for each of the one or more switching devices **204,** as an indication of change in switching state of the corresponding one of the one or more switching devices **204.** The control unit **210** is further configured to calculate a correlation between the one or more current sensors **206** based on the measurements of current therethrough and the detected change in the switching state of the associated one or more switching devices **204.** The control unit **210** is further configured to determine relative installation directions of each of the one or more current sensors **206** based on the determined correlation therebetween and generate a network topology of the electric grid **202** based on the determined relative installation directions of each of the one or more current sensors **206.**

Referring to FIGs. 3A to 3C, illustrated are schematic drawings of the different electric grids **202** managed by the method **100** or the system **200,** in accordance with various exemplary embodiments. Herein, the problem of fault detection in multiple branched networks is illustrated in a simplistic manner. Herein, the electric grid comprises the one or more switching devices and the one or more current sensors associated therewith, wherein the one or more current sensors are represented by a circle, the one or more switching devices are represented by a square, and whereas the potential fault locations are marked by a cross thereat. Typically, in any distribution service area covered by distribution grid operator, the supply comes from the high voltage grid and the phases are of the same order. Therefore, when the switching state changes, the direction of the relative current changes. This, in turn, is manifested by a sign change in $I_a$. Therefore, any sign change of $I_a$ is a real time signal, that indicates occurrence of a change of switching state.

Referring to FIG. 3A, illustrated is a first electric grid **300A** managed by the method **100** or the system **200,** in accordance with an embodiment. As shown, the first electric grid **300A** comprises two current sensors **206A, 206B** i.e., a first sensor **206A** and a second sensor **206B** in the electric grid **300A,** wherein the first sensor **206B** is closer to substation and the second sensor **206A** is a few kilometers away such that there may be a few secondary substations therebetween. Herein, the power 'P$_1$' measured by the first sensor is approximately equal to the power measured by the second sensor P$_2$ in addition to the value of the load carried out by the secondary substations between the two sensors. Generally, in power flow and load analysis, $P_1$, $P_2$ and $P_x$ as random variables with some defined variances, autocorrelation and similar statistical properties. Therefore, obviously $P_1$ and $P_2$ are also correlated as follows: $P_1 = P_2 + P_x$.

Referring to FIG. 3B, illustrated is a second electric grid **300B** managed by the method **100** or the system **200,** in accordance with another embodiment. As shown, the second electric grid **300B** comprises a first current sensor **206** operating between two switching devices, i.e., a first switching device **204A** and a second switching device **204B.** Moreover, in cases wherein the sensors are located such that, the sensors are fed by two different substations **X** and **Y** or are located in in different branches of the electric grid, and there should be a little correlation therebetween. Since, in practical settings it is non-zero due to the spuriousness experienced in correlations, especially with smaller sample sizes and due to some common sources (e.g., certain times instants triggering similar actions in different consumers).

Referring to FIG. 3C, illustrated is a first electric grid **300C** managed by the method **100** or the system **200,** in accordance with an embodiment. As shown, the third electric grid **300C** comprises one or more current sensors **206A** to **206H** (eight sensors, as shown) arranged between two different substations **X, Y** and one or more switching devices **204A, 204B** (two reclosers, as shown). It may be observed that a first current sensor **206A** of the one or more current sensors **206A** to **206H** is mutually correlated to a second current sensor **206B** and a third current sensor **206C**. However, the second current sensor **206B** and the third current sensor **206C** are not correlated to each other. Thus, the determination of the power or current through any of the three nodes (or current sensors) may be determined by determining the mutual correlation therebetween. Thus, considering the electric grid of the present example, $X = Y + Z$ and thus, the corresponding statistical correlation becomes:

$$p_{XY} = \frac{E[(y+z)y]}{\sqrt{E[(y+z)^2]}\sigma_y} = p_{XY} = \frac{\sigma_y}{\sqrt{\sigma_y^2 + \sigma_z^2}}.$$

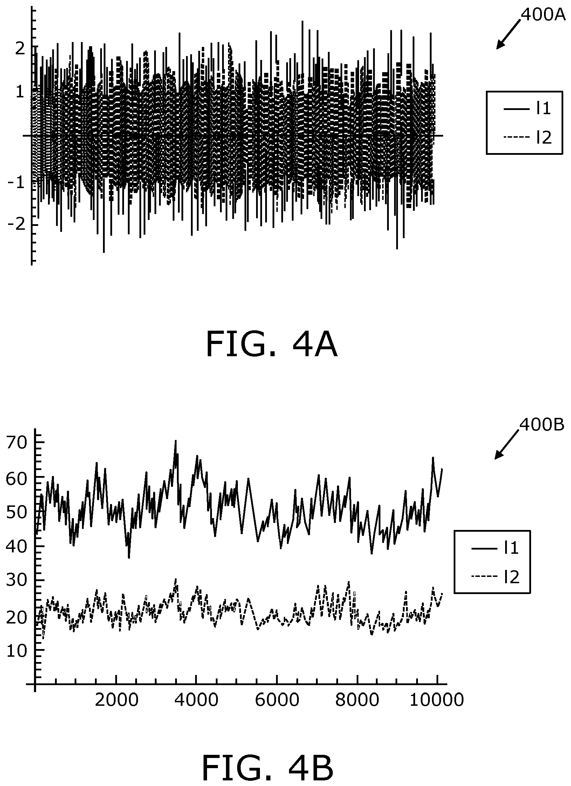

Referring to FIGs. 4A and 4B, illustrated are graphical illustrations **400A, 400B** of time series associated with the current measurements flowing through the electric grid, in accordance with an embodiment. As shown in FIG. 4A, illustrated are the covariance values of the currents measured by the one or more current sensors in the electric grid. As shown in FIG. 4B, illustrated are the raw values of the phase currents measured by the one or more current sensors in the electric grid.

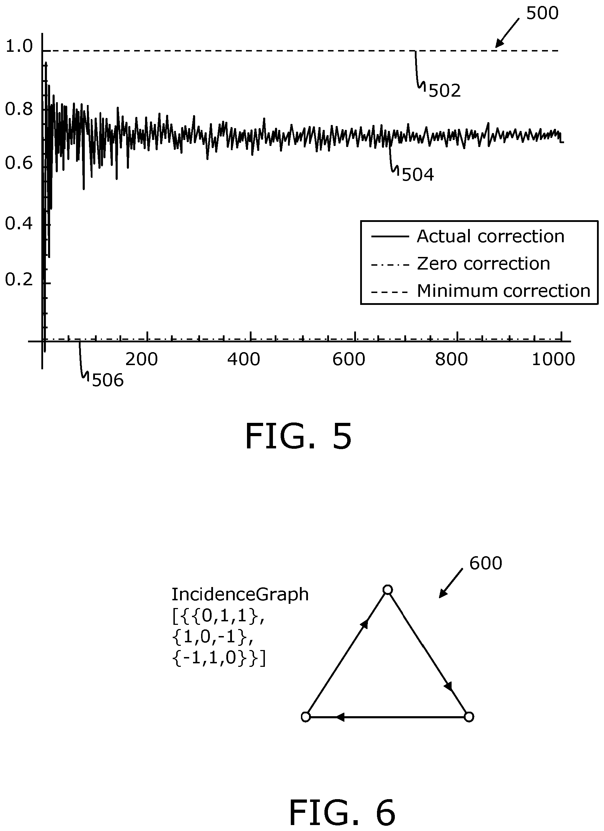

Referring to FIG. 5, illustrated is a graphical illustration **500** depicting relationship between the number of samples and the magnitude of correlation between the one or more current sensors., in accordance with an embodiment. Herein, the X- axis represents the number of samples observed and whereas the Y-axis represents the magnitude of the correlation between the one or more current sensors. As shown, the line **502** represents a maximum correlation between the one or more current sensors. Typically, the maximum correlation is indicative of the one or more current sensors being present in the same branch or feeder network. Further, a curve **504** (as shown) represents the actual correlation between the one or more current sensors and whereas a line **506** (as shown) represents a minimum correlation (indicative of the one or more current sensors not being connected to each other) between the one or more current sensors. As indicated by the actual correlation curve **504,** at least 200 to 300 samples may be required for an effective and accurate approximation.

Referring to FIG. 6, illustrated is an exemplary network topology **600** of an electric grid **300C** generated via the method **100** or the system **200,** in accordance with various embodiments.

Hereinafter, FIG. 6 has been described in conjunction with FIG. 3C. As shown, the nodes **206B, 206D** and **206G** have an inverted polarity. Applying the analytics on the derived current measurements to derive the correlation matrix or incidence matrix:

$$\begin{pmatrix} x & -1 & 1 & -1 & 0 & 0 & 0 & 0 \\ -1 & x & 0 & 0 & 0 & 0 & 0 & 0 \\ 1 & 0 & x & -1 & 0 & 0 & 0 & 0 \\ -1 & 0 & -1 & x & 0 & 0 & 0 & 0 \\ 0 & 0 & 0 & 0 & x & 0 & 0 & 1 \\ 0 & 0 & 0 & 0 & 0 & x & 0 & 1 \\ 0 & 0 & 0 & 0 & 0 & 0 & x & -1 \\ 0 & 0 & 0 & 0 & 1 & 1 & -1 & x \end{pmatrix}$$

Consequently, to determine the network topology, the corresponding incidence graph or directed graph is generated as shown in FIG. 6 Modifications to embodiments of the present disclosure described in the foregoing are possible without departing from the scope of the present invention as defined by the accompanying claims. Expressions such as "including", "comprising", "incorporating", "have", "is" used to describe and claim the present disclosure are intended to be construed in a non-exclusive manner, namely allowing for items, components or elements not explicitly described also to be present. Expressions such as "may" and "can" are used to indicate optional features, unless indicated otherwise in the foregoing. Reference to the singular is also to be construed to relate to the plural. The scope of the invention is defined by the appended claims.

**Claims**

1. A method (100) for management of an electric grid, the electric grid comprising one or more switching devices and one or more current sensors associated therewith, the method (100) comprising:

   - receiving information about measurements of current from each of the one or more current sensors in the electric grid;
   - approximating a proxy for a relative current through each of the one or more switching devices based on the received information, wherein the proxy for the relative current indicates the relative power flow or the load current in the one or more switching devices and provides measure of the direction of switching state in the one or more switching devices;
   - detecting a change in polarity of the proxy for the relative current for each of the one or more switching devices, as an indication of change in switching state of the corresponding one of the one or more switching devices;
   - calculating correlation between the one or more current sensors based on the measurements of current therethrough and the detected change in the switching state of the associated one or more switching devices;
   - determining relative installation directions of each of the one or more current sensors based on the determined correlation therebetween; and
   - generating a network topology of the electric grid based on the determined relative installation directions of each of the one or more current sensors, wherein a correlation matrix is generated based on the determined relative installation directions of each of the one or more current sensors and the calculated correlation between each of the one or more current sensors to generate the network topology of the electric grid,

   wherein the method (100) comprising determining a fault location, in case of a fault in the electric grid, corresponding to one of the one or more switching devices in the electric grid utilizing information about the generated network topology of the electric grid, wherein the fault location is extracted accurately when fault transients are detected by at least two sensors using relative timings based on GPS time stamps.

2. A method (100) according to claim 1, wherein approximating the proxy for the relative current through each of the one or more switching devices comprises:

   - transforming measurements of current to sequence space, to determine a positive sequence current component and a negative sequence current component for each of phase orders for the measurements of current; and
   - combining the positive sequence current component and the negative sequence current component, for approximating the proxy for the relative current.

3. A method (100) according to claim 2, wherein combining the positive sequence current component and the negative sequence current component comprises using larger of the positive sequence current component and the negative sequence current component.

4. A method (100) according to any of claims 1-3, wherein the correlation between the one or more current sensors is calculated based on a covariance of the measurements of current therethrough.

5. A method (100) according to claim 4 further comprising using a signal-to-noise ratio value in an inversely proportional relationship for calculating the correlation between the one or more current sensors.

6. A method (100) according to any of claims 4-5 further comprising using an average of at least a predefined number of covariances of the measurements for calculating the correlation between the one or more current sensors.

7. A method (100) according to any of preceding claims, wherein the relative installation direction of two of the one or more current sensors is determined to be same if the calculated correlation therebetween is close to 1 and to be opposite if the calculated correlation therebetween is close to -1.

8. A system (200) for management of an electric grid (202), the electric grid (202) comprising one or more switching devices (204) and one or more current sensors (206) associated therewith, the system (200) comprising:

- a sensing unit (208) coupled with each of the one or more current (206) sensors to collect and transmit information about measurements of current by the corresponding current sensors in the electric grid; and
- a control unit (210) in signal communication with each of the sensing units, the control unit (210) configured to:

- receive information about measurements of current from each of the one or more current sensors in the electric grid;
- approximate a proxy for a relative current through each of the one or more switching devices (204) based on the received information, wherein the proxy for the relative current indicates the relative power flow or the load current in the one or more switching devices and provides measure of the direction of switching state in the one or more switching devices;
- detect a change in polarity of the proxy for the relative current for each of the one or more switching devices, as an indication of change in switching state of the corresponding one of the one or more switching devices;
- calculate correlation between the one or more current sensors based on the measurements of current therethrough and the detected change in the switching state of the associated one or more switching devices;
- determine relative installation directions of each of the one or more current sensors based on the determined correlation therebetween; and
- generate a network topology of the electric grid based on the determined relative installation directions of each of the one or more current sensors, wherein a correlation matrix is generated based on the determined relative installation directions of each of the one or more current sensors and the calculated correlation between each of the one or more current sensors to generate the network topology of the electric grid,

wherein the control unit (210) is further configured to determine a fault location, in case of a fault in the electric grid, corresponding to one of the one or more switching devices in the electric grid utilizing the information about the generated network topology of the electric grid, wherein the fault location is extracted accurately when fault transients are detected by at least two sensors using relative timings based on GPS time stamps.

9. A system (200) according to claim 8, wherein for approximating the proxy for the relative current through each of the one or more switching devices (204), the control unit (210) is configured to:

- transform measurements of current to sequence space, to determine a positive sequence current component and a negative sequence current component for each of phase orders for the measurements of current; and
- combine the positive sequence current component and the negative sequence current component, for approximating the proxy for the relative current.

10. A system (200) according to any of claims 8 or 9, wherein the control unit (210) is configured to calculate the correlation between the one or more current sensors (206) based on a covariance of the measurements of current therethrough.

11. A system (200) according to any of claims 8-10, wherein the control unit (210) is configured to determine the relative installation direction of two of the one or more current sensors (206) to be same if the calculated correlation therebetween is close to 1 and to be opposite if the calculated correlation therebetween is close to -1.

12. A system (200) according to any of claims 8-11, wherein the one or more switching devices (204) are one of: disconnectors and reclosers.

13. A system (200) according to any of claims 8-12, wherein the one or more current sensors (206) are Rogowski coils.

**Patentansprüche**

1. Verfahren (100) zum Verwalten eines elektrischen Netzes, wobei das elektrische Netz eine oder mehrere Schaltvorrichtungen und eine oder mehrere damit verbundene Stromsensoren umfasst, das Verfahren (100) umfassend:

- Empfangen von Informationen über Strommessungen von jedem der einen oder mehreren Stromsensoren in dem elektrischen Netz;
- Approximieren eines Proxys für einen relativen Strom durch jede der einen oder mehreren Schaltvorrichtungen basierend auf den empfangenen Informationen, wobei der Proxy für den relativen Strom den relativen Leistungsfluss oder den Laststrom in den einen oder mehreren Schaltvorrichtungen anzeigt und ein Maß für die Richtung des Schaltzustands in den einen oder mehreren Schaltvorrichtungen bereitstellt;

- Erfassen einer Änderung der Polarität des Proxys für den relativen Strom für jede der einen oder mehreren Schaltvorrichtungen als Anzeige einer Änderung des Schaltzustands der entsprechenden einen der einen oder mehreren Schaltvorrichtungen;

- Berechnen einer Korrelation zwischen dem einen oder den mehreren Stromsensoren basierend auf den Strommessungen dadurch und der erfassten Änderung im Schaltzustand der zugeordneten einen oder mehreren Schaltvorrichtungen;

- Bestimmen relativer Installationsrichtungen jedes der einen oder mehreren Stromsensoren basierend auf der bestimmten Korrelation zwischen diesen; und

- Erzeugen einer Netzwerktopologie des elektrischen Netzes basierend auf den bestimmten relativen Installationsrichtungen jedes der einen oder mehreren Stromsensoren, wobei eine Korrelationsmatrix basierend auf den bestimmten relativen Installationsrichtungen jedes der einen oder mehreren Stromsensoren und der berechneten Korrelation zwischen jedem der einen oder mehreren Stromsensoren erzeugt wird, um die Netzwerktopologie des elektrischen Netzes zu erzeugen,

wobei das Verfahren (100) das Bestimmen einer Fehlerstelle umfasst, im Falle eines Fehlers in dem elektrischen Netz, entsprechend einer der einen oder mehreren Schaltvorrichtungen in dem elektrischen Netz unter Verwendung von Informationen über die erzeugte Netzwerktopologie des elektrischen Netzes, wobei die Fehlerstelle akkurat extrahiert wird, wenn Fehlertransienten durch mindestens zwei Sensoren unter Verwendung relativer Zeitsteuerungen basierend auf GPS-Zeitstempeln erfasst werden.

2. Verfahren (100) nach Anspruch 1, wobei das Approximieren des Proxys für den relativen Strom durch jede der einen oder mehreren Schaltvorrichtungen umfasst:

- Umwandeln von Strommessungen in den Sequenzraum, um eine positive Sequenzstromkomponente und eine negative Sequenzstromkomponente für jede der Phasenfolgen für die Strommessungen zu bestimmen; und
- Kombinieren der positiven Sequenzstromkomponente und der negativen Sequenzstromkomponente zum Approximieren des Proxys für den relativen Strom.

3. Verfahren (100) nach Anspruch 2, wobei das Kombinieren der positiven Sequenzstromkomponente und der negativen Sequenzstromkomponente das Verwenden der größeren der positiven Sequenzstromkomponente und der negativen Sequenzstromkomponente umfasst.

4. Verfahren (100) nach einem der Ansprüche 1 bis 3, wobei die Korrelation zwischen dem einen oder den mehreren Stromsensoren basierend auf einer Kovarianz der Strommessungen dadurch berechnet wird.

5. Verfahren (100) nach Anspruch 4, ferner umfassend das Verwenden eines Signal-Rausch-Verhältnis-Werts in einer umgekehrt proportionalen Beziehung zur Berechnung der Korrelation zwischen dem einen oder den mehreren Stromsensoren.

6. Verfahren (100) nach einem der Ansprüche 4 bis 5, ferner umfassend das Verwenden eines Durchschnitts von mindestens einer vorgegebenen Anzahl von Kovarianzen der Messungen zur Berechnung der Korrelation zwischen dem einen oder den mehreren Stromsensoren.

7. Verfahren (100) nach einem der vorstehenden Ansprüche, wobei die relative Installationsrichtung von zwei der einen oder mehreren Stromsensoren als gleich bestimmt wird, wenn die berechnete Korrelation zwischen diesen nahe 1 ist, und als entgegengesetzt bestimmt wird, wenn die berechnete Korrelation zwischen diesen nahe -1 ist.

8. System (200) zum Verwalten eines elektrischen Netzes (202), das elektrische Netz (202) umfassend eine oder mehrere Schaltvorrichtungen (204) und eine oder mehrere damit verbundene Stromsensoren (206), das System (200) umfassend:

- eine Erfassungseinheit (208), die mit jedem der einen oder mehreren Stromsensoren (206) gekoppelt ist, um Informationen über Strommessungen durch die entsprechenden Stromsensoren im elektrischen Netz zu sammeln und zu übertragen; und
- eine Steuereinheit (210) in Signalverbindung mit jeder der Erfassungseinheiten, wobei die Steuereinheit (210) konfiguriert ist zum:

- Empfangen von Informationen über Strommessungen von jedem der einen oder mehreren Stromsensoren in dem elektrischen Netz;
- Approximieren eines Proxys für einen relativen Strom durch jede der einen oder mehreren Schaltvorrichtungen (204) basierend auf den empfangenen Informationen, wobei der Proxy für den relativen Strom den relativen Leistungsfluss oder den Laststrom in den einen oder mehreren Schaltvorrichtungen anzeigt und ein Maß für die Richtung des Schaltzustands in den einen oder mehreren Schaltvorrichtungen bereitstellt;
- Erfassen einer Änderung der Polarität des Proxys für den relativen Strom für jede der einen oder mehreren Schaltvorrichtungen als Anzeige einer Änderung des Schaltzustands der entsprechenden einen der einen oder mehreren Schaltvorrichtungen;
- Berechnen einer Korrelation zwischen dem einen oder den mehreren Stromsensoren basierend auf den Strommessungen dadurch und der erfassten Änderung im Schaltzustand der damit verbundenen einen oder mehreren Schaltvorrichtungen;
- Bestimmen von relativen Installationsrichtungen jedes der einen oder mehreren Stromsensoren basierend auf der bestimmten Korrelation dazwischen; und
- Erzeugen einer Netzwerktopologie des elektrischen Netzes basierend auf den bestimmten relativen Installationsrichtungen jedes der einen oder mehreren Stromsensoren, wobei eine Korrelationsmatrix basierend auf den bestimmten relativen Installationsrichtungen jedes der einen oder mehreren Stromsensoren und der berechneten Korrelation zwischen jedem der einen oder mehreren Stromsensoren erzeugt wird, um die Netzwerktopologie des elektrischen Netzes zu erzeugen,

wobei die Steuereinheit (210) ferner konfiguriert ist, eine Fehlerstelle zu bestimmen, im Falle eines Fehlers in dem elektrischen Netz, entsprechend einer der einen oder mehreren Schaltvorrichtungen in dem elektrischen Netz unter Verwendung der Informationen über die erzeugte Netzwerktopologie des elektrischen Netzes, wobei die Fehlerstelle akkurat extrahiert wird, wenn Fehlertransienten durch mindestens zwei Sensoren unter Verwendung relativer Zeitsteuerungen basierend auf GPS-Zeitstempeln erfasst werden.

9. System (200) nach Anspruch 8, wobei zum Approximieren des Proxys für den relativen Strom durch jede der einen oder mehreren Schaltvorrichtungen (204) die Steuereinheit (210) konfiguriert ist zum:

- Transformieren von Strommessungen in den Sequenzraum, um eine positive Sequenzstromkomponente und eine negative Sequenzstromkomponente für jede der Phasenfolgen für die Strommessungen zu bestimmen; und
- Kombinieren der positiven Sequenzstromkomponente und der negativen Sequenzstromkomponente zum Approximieren des Proxys für den relativen Strom.

10. System (200) nach einem der Ansprüche 8 oder 9, wobei die Steuereinheit (210) konfiguriert ist, die Korrelation zwischen dem einen oder den mehreren Stromsensoren (206) basierend auf einer Kovarianz der Strommessungen dadurch zu berechnen.

11. System (200) nach einem der Ansprüche 8 bis 10, wobei die Steuereinheit (210) konfiguriert ist, die relative Installationsrichtung von zwei der einen oder mehreren Stromsensoren (206) als gleich zu bestimmen, wenn die berechnete Korrelation zwischen diesen nahe 1 ist, und als entgegengesetzt, wenn die berechnete Korrelation zwischen diesen nahe -1 ist.

12. System (200) nach einem der Ansprüche 8 bis 11, wobei die eine oder mehreren Schaltvorrichtungen (204) eines von Folgendem sind: Trennschalter und Wiedereinschalter.

13. System (200) nach einem der Ansprüche 8 bis 12, wobei der eine oder die mehreren Stromsensoren (206) Rogowski-Spulen sind.

## Revendications

1. Procédé (100) de gestion d'un réseau électrique, le réseau électrique comprenant un ou plusieurs dispositifs de commutation et un ou plusieurs capteurs de courant qui lui sont associés, le procédé (100) comprenant :

- la réception d'informations concernant des mesures de courant à partir de chacun du ou des capteurs de courant dans le réseau électrique ;

- l'approximation d'un proxy pour un courant relatif à travers chacun du ou des dispositifs de commutation en fonction des informations reçues, dans lequel le proxy pour le courant relatif indique le flux de puissance relatif ou le courant de charge dans le ou les dispositifs de commutation et fournit une mesure de la direction d'état de commutation dans le ou les dispositifs de commutation ;

- la détection d'un changement dans la polarité du proxy pour le courant relatif pour chacun du ou des dispositifs de commutation, comme une indication de changement dans un état de commutation du dispositif de commutation correspondant du ou des dispositifs de commutation ;

- le calcul d'une corrélation entre le ou les capteurs de courant en fonction des mesures de courant à travers celui-ci et le changement détecté dans l'état de commutation du ou des dispositifs de commutation associés ;

- la détermination de directions d'installation relatives de chacun du ou des capteurs de courant en fonction de la corrélation déterminée entre eux ; et

- la génération d'une topologie de réseau du réseau électrique en fonction des directions d'installation relatives déterminées de chacun du ou des capteurs de courant, dans lequel une matrice de corrélation est générée en fonction des directions d'installation relatives déterminées de chacun du ou des capteurs de courant et de la corrélation calculée entre chacun du ou des capteurs de courant pour générer la topologie de réseau du réseau électrique,

dans lequel le procédé (100) comprend la détermination d'un emplacement de défaut, en cas de défaut dans le réseau électrique, correspondant à un dispositif de commutation du ou des dispositifs de commutation dans le réseau électrique utilisant des informations concernant la topologie de réseau générée du réseau électrique, dans lequel l'emplacement de défaut est extrait avec précision lorsque des transitoires de défaut sont détectés par au moins deux capteurs à l'aide de synchronisations relatives basées sur des horodateurs GPS.

2. Procédé (100) selon la revendication 1, dans lequel l'approximation du proxy pour le courant relatif à travers chacun du ou des dispositifs de commutation comprend :

- la transformation de mesures de courant en espace séquentiel, pour déterminer une composante de courant de séquence positive et une composante de courant de séquence négative pour chacun des ordres de phase pour les mesures de courant ; et

- la combinaison de la composante de courant de séquence positive et de la composante de courant de séquence négative, pour approximer le proxy du courant relatif.

3. Procédé (100) selon la revendication 2, dans lequel la combinaison de la composante de courant de séquence positive et de la composante de courant de séquence négative comprend l'utilisation d'une plus grande de la composante de courant de séquence positive et de la composante de courant de séquence négative.

4. Procédé (100) selon l'une quelconque des revendications 1 à 3, dans lequel la corrélation entre le ou les capteurs de courant est calculée en fonction d'une covariance des mesures de courant à travers ceux-ci.

5. Procédé (100) selon la revendication 4, comprenant en outre l'utilisation d'une valeur de rapport signal sur bruit dans une relation inversement proportionnelle pour calculer la corrélation entre le ou les capteurs de courant.

6. Procédé (100) selon l'une quelconque des revendications 4 à 5, comprenant en outre l'utilisation d'une moyenne d'au moins un nombre prédéfini de covariances des mesures pour calculer la corrélation entre le ou les capteurs de courant.

7. Procédé (100) selon l'une quelconque des revendications précédentes, dans lequel la direction d'installation relative de deux capteurs de courant du ou des capteurs de courant est déterminée comme étant la même si la corrélation calculée entre eux est proche de 1 et comme étant opposée si la corrélation calculée entre eux est proche de -1.

8. Système (200) de gestion d'un réseau électrique (202), le réseau électrique (202) comprenant un ou plusieurs dispositifs de commutation (204) et un ou plusieurs capteurs de courant (206) qui lui sont associés, le système (200) comprenant :

- une unité de détection (208) couplée à chacun du ou des capteurs de courant (206) pour collecter et transmettre des informations concernant des mesures de courant par les capteurs de courant correspondants dans le réseau électrique ; et

- une unité de commande (210) en communication de signal avec chacune des unités de détection, l'unité de commande (210) étant configurée pour :

- recevoir des informations concernant des mesures de courant de chacun du ou des capteurs de courant dans le réseau électrique ;
- approximer un proxy pour un courant relatif à travers chacun du ou des dispositifs de commutation (204) en fonction des informations reçues, dans lequel le proxy pour le courant relatif indique le flux de puissance relatif ou le courant de charge dans le ou les dispositifs de commutation et fournit une mesure de la direction d'état de commutation dans le ou les dispositifs de commutation ;
- détecter un changement dans la polarité du proxy pour le courant relatif pour chacun du ou des dispositifs de commutation, comme une indication d'un changement dans un état de commutation du dispositif de commutation correspondant du ou des dispositifs de commutation ;
- calculer une corrélation entre le ou les capteurs de courant en fonction des mesures du courant à travers ceux-ci et le changement détecté dans l'état de commutation du ou des dispositifs de commutation associés ;
- déterminer des directions d'installation relatives de chacun du ou des capteurs de courant en fonction de la corrélation déterminée entre eux ; et
- générer une topologie de réseau du réseau électrique en fonction des directions d'installation relatives déterminées de chacun du ou des capteurs de courant, dans lequel une matrice de corrélation est générée en fonction des directions d'installation relatives déterminées de chacun du ou des capteurs de courant et de la corrélation calculée entre chacun du ou des capteurs de courant pour générer la topologie de réseau du réseau électrique,

dans lequel l'unité de commande (210) est en outre configurée pour déterminer un emplacement de défaut, en cas de défaut dans le réseau électrique, correspondant à un dispositif de commutation du ou des dispositifs de commutation dans le réseau électrique utilisant les informations concernant la topologie de réseau générée du réseau électrique, dans lequel l'emplacement de défaut est extrait avec précision lorsque des transitoires de défaut sont détectés par au moins deux capteurs à l'aide de synchronisations relatives basées sur des horodateurs GPS.

9.  Système (200) selon la revendication 8, dans lequel, pour approximer le proxy pour le courant relatif à travers chacun du ou des dispositifs de commutation (204), l'unité de commande (210) est configurée pour :

- transformer des mesures de courant en espace séquentiel, pour déterminer une composante de courant de séquence positive et une composante de courant de séquence négative pour chacun des ordres de phase pour les mesures de courant ; et
- combiner la composante de courant de séquence positive et la composante de courant de séquence négative, pour approximer le proxy pour le courant relatif.

10. Système (200) selon l'une quelconque des revendications 8 ou 9, dans lequel l'unité de commande (210) est configurée pour calculer la corrélation entre le ou les capteurs de courant (206) en fonction d'une covariance des mesures de courant à travers ceux-ci.

11. Système (200) selon l'une quelconque des revendications 8 à 10, dans lequel l'unité de commande (210) est configurée pour déterminer que la direction d'installation relative de deux capteurs de courant du ou des capteurs de courant (206) est la même si la corrélation calculée entre eux est proche de 1 et est opposée si la corrélation calculée entre eux est proche de -1.

12. Système (200) selon l'une quelconque des revendications 8 à 11, dans lequel le ou les dispositifs de commutation (204) sont l'un parmi : sectionneurs et réenclencheurs.

13. Système (200) selon l'une quelconque des revendications 8 à 12, dans lequel le ou les capteurs de courant (206) sont des bobines de Rogowski.

FIG. 1

FIG. 2

○ Current sensors

✕ Potential fault locations

☐ Switching device

FIG. 3A

FIG. 3B

FIG. 3C

400A

I1
I2

# FIG. 4A

400B

I1
I2

# FIG. 4B

FIG. 5

FIG. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 11183879 B1